(19)

Europäisches
Patentamt
European
Patent Office
Office européen
des brevets

(11) **EP 1 597 631 B1**

(12) **EUROPEAN PATENT SPECIFICATION**

(45) Date of publication and mention
of the grant of the patent:
**22.07.2009 Bulletin 2009/30**

(51) Int Cl.:
***G03F 7/20*** (2006.01)

(21) Application number: **04715238.4**

(86) International application number:
**PCT/CN2004/000149**

(22) Date of filing: **27.02.2004**

(87) International publication number:
**WO 2004/077162 (10.09.2004 Gazette 2004/37)**

(54) **MULTIPLE EXPOSURE METHOD FOR CIRCUIT PERFORMANCE IMPROVEMENT AND MASKSET**

MEHRFACHBELICHTUNGSVERFAHREN ZUR SCHALTUNGSLEISTUNGSVERBESSERUNG UND MASKENSET

PROCEDE D'EXPOSITION MULTIPLE POUR AMELIORATION DU FONCTIONNEMENT DES CIRCUITS ET ASSORTIMENT DES MASQUES

(84) Designated Contracting States:
**DE FR GB**

(30) Priority: **27.02.2003 US 450496 P**

(43) Date of publication of application:
**23.11.2005 Bulletin 2005/47**

(73) Proprietor: **The University of Hong Kong
Hong Kong (CN)**

(72) Inventors:
• **WANG, Jun
  Hong Kong (CN)**

• **WONG, K. Alfred
  Santa Clara, CA 95051 (US)**

(74) Representative: **Schwarze, Holm et al
Zacco Denmark A/S
Hans Bekkevolds Allé 7
2900 Hellerup (DK)**

(56) References cited:
| | |
|---|---|
| WO-A1-00/25181 | CN-A- 1 129 852 |
| US-A- 5 686 223 | US-A- 6 074 787 |
| US-A- 6 150 059 | US-A1- 2002 006 734 |
| US-A1- 2002 045 134 | US-A1- 2002 094 482 |
| US-A1- 2002 166 107 | US-B1- 6 518 180 |

**Description**

CROSS REFERENCE TO RELATED APPLICATION

The present application claims priority to United States Provisional Application number 60/450,496, filed February 27, 2003.

FIELD OF THE INVENTION

The present invention relates to optical lithography. More specifically, the invention relates to advanced optical lithography methods for decreasing the minimum grid pitch of a regularly placed layout. The method of the invention can be used to decrease circuit area and improve circuit performance.

BACKGROUND OF THE INVENTION

Optical lithography remains the dominant technology for integrated circuit fabrication even as the size of the semiconductor features shrink to the 100 - 200 nm range. The minimum size that can be defined is called the critical dimension, CD, and is given by the following equation:

$$CD = k_1 \frac{\lambda}{NA} \qquad\qquad (1)$$

where $\lambda$ is the wavelength of the exposure light, $NA$ is the numerical aperture of the projection system, and $k_1$ is the process-related factor. The CD may be reduced by decreasing $k_1$ and for particular exposure systems having a fixed $\lambda$ and $NA$, decreasing $k_1$ is the only method of decreasing CD. The image quality, however, degrades noticeably when $k_1$ is reduced below 0.75.

Resolution enhancement techniques (RETs) are employed to improve the image quality when $k_1$ is less than 0.75. Examples of RETs include modified illumination, phase-shift masking (PSM), and optical proximity correction (OPC).

A.K Wong, "Resolution Enhancement Techniques in Optical Lithography," SPIE Press, Washington, 2001 discloses several kinds of illumination modes that are suitable for different mask patterns. Optimizing the illumination source, however, is very difficult because image quality not only depends on the size and shapes of the pattern but also depends on the local environment of each mask feature. For example, randomly placed contacts produce regions of densely spaced contacts and regions of sparsely spaced contacts on the same mask. An illumination source optimized for the dense region will result in high image quality in the dense region but may also result in poor image quality in the sparse region.

US 2002/0045134 discloses a method of manufacturing a semiconductor integrated circuit, the method comprising transferring a pattern to a semiconductor wafer with an aligning laser beam of the modified lightning (a lightning system where the light intensity at the center is lowered and includes the ultra-high resolution technique based on the inclined lightning or the like and a pupil filter) via a photomask MK, the photomask MK allocating, to provide periodicity, the main apertures to transfer the pattern as apertures formed by removing a part of the half-tone film on the photomask substrate and the auxiliary apertures not resolved on the semiconductor wafer as the apertures formed by removing a part of the half-tone film is used to improve the resolution of the pattern. Additionally, a set of virtual lines is disclosed in which a set of holes are arranged. Further, a set of auxiliary apertures arranged along the virtual lines are disclosed and said auxiliary apertures provide an aperture pattern on the semiconductor wafer that is not resolved.

US 6,150,059 discloses a method and a photomask for the formation of at least a part of a plurality of pattern parts of a pattern of a semiconductor device. Further, US 6,150,059 discloses two photomasks: a bit line contact hole mask comprising bit contact holes and a capacitive contact hole mask comprising capacitive contact holes. These holes are transferred to a wafer during lithography. Additionally, the two photomasks comprise auxiliary holes which are smaller than the resolving limit and thus are not transferred to the wafer. The holes and the auxiliary holes are disposed at the points of intersection of a matrix. The matrix of the bit line contact hole mask and the matrix of the capacitive contact hole mask are identical. The distribution of holes and auxiliary holes in the matrices may vary between the two photomasks. Further, the auxiliary holes are disposed at the intersecting points of the matrix where no contact holes are positioned and therefore each matrix point at the two photomasks is covered either by a hole or an auxiliary hole.

US 2002/0166107 discloses a method of H-V partitioning of a photomask into a V-mask and a H-mask. The V-mask and the H-mask are generally complementary and each mask contains critical features in a given orientation, appropriate shielding for the complementary orientation and special geometrical modification of the features at the intersections of VC (vertical critical) and HC (horizontal critical) features. The masks may additionally contain any other type of optical proximity correction technique and/or resolution enhancement techniques.

US 6,074,787 discloses a method of making a mask pattern including an original pattern to be printed on a wafer substrate and an auxiliary pattern for improving printing accuracy of the original pattern. The method comprising a step of providing an auxiliary pattern forbidden region around an original pattern (step S1); a step of providing an auxiliary pattern formation region around the auxiliary pattern forbidden region based on the auxiliary pattern forbidden region provided in step S1 (step S2); and a step of forming an auxiliary pattern of specific width based on the auxiliary pattern formation region provided in step S2 (step S3).

US 2002/0094482 discloses a method of lithographically printing a mask pattern on a substrate, wherein the mask pattern includes features with diverse pitches. These features may include device features such as vias or contact holes and lines in integrated circuits. The method comprises splitting the mask pattern into a plurality of masks, wherein one or more of the masks contains relatively tightly nested features and one or more of the masks contains relatively isolated features. Each of the plurality of masks is then successively exposed on a photoresist layer on the substrate.

By considering circuit manufacturability in the layout design, it is expected that the $k_1$, factor can be further reduced by fabrication-friendly layout in which the circuit pattern configurations are limited to facilitate lithography optimization.

Excessive lithography friendliness may be so restrictive on layout compaction that circuit area increases unacceptably. Therefore, there remains a need for methods that allow for lithography optimization to reduce the CD of the circuit while not increasing the growth of the circuit area.

SUMMARY

One embodiment of the present invention is directed to a method of imaging features onto a wafer, the method comprising establishing a first grid having grid pitches; arranging a plurality of real features on the first grid; arranging a plurality of assist features on the first grid, the assist features being sized such that they do not print but nevertheless create a mask spectrum that allows an illumination to be optimized; creating two masks, the first mask including a first subset of the plurality of real features and the second mask containing a second subset of the plurality of real features; and imaging the real features onto the wafer wherein the first mask includes a second grid and includes a first subset of the plurality of assist features; and the second mask includes a third grid and includes a second subset of the plurality of assist features; and the second grid and the third grid are sparser than the first grid.

The method is suited for the imaging of regularly-placed fabrication-friendly contacts onto a wafer. The regular placement of contacts enables more effective use of resolution enhancement technologies, which in turn allows in a reduction of the minimum contact pitch and size.

One approach of fabrication-friendly contacts is to snap contacts on grid points and introduce assist contacts at the grid points that do not have a contact. The assist contacts are sized such that they do not print onto the die but nevertheless create a mask spectrum that allows the illumination to be optimized.

For the application of regularly-placed contacts on standard cells in application-specific integrated circuits (ASICs), contacts and assist contacts are placed on a grid with pitch smaller than the minimum pitch of single-exposure lithography to get a smaller circuit area. Although the pitch between contacts and assist contacts is smaller than the minimum pitch of single-exposure lithography, the pitches between any two real contacts satisfies the design rules of single-exposure lithography.

The dense grid of contacts and assist contacts are separated into two sparser grids on two masks with the grid pitch occurring at the diagonal direction:

$$p_{\min} = \sqrt{p_x^2 + p_y^2}, \qquad\qquad (2)$$

where $p_{\min}$ is the grid pitch of the sparser grid, $p_x$ and $p_y$ are two grid pitches of the dense grid in two perpendicular directions. Although $p_x$ and $p_y$ are smaller than the <u>minimum</u> pitch of single-exposure lithography, $p_{\min}$ can be larger. Thus, the two sparser grids are within the resolution limit of one exposure. Sequential exposures of these two masks print all contacts onto the die.

With the <u>minimum</u> grid pitch occurring at the diagonal direction in the two exposures, the poles of quadrupole illumination for the contact lithography should be placed on the x- and y- axes with distances to zero point determined by $p_x$ and $p_y$.

BRIEF DESCRIPTION OF THE DRAWINGS

The invention will be described by reference to the preferred and alternative embodiments thereof in conjunction with the drawings in which:

Fig. 1a-d is an illustration of one embodiment of the present invention;

Fig. 2a is a diagram of the illumination source used for an X-Y grid layout;

Fig. 2b is a diagram of the illumination source used in the embodiment of Fig. 1;

Fig. 3 is a diagram illustrating the feature of a standard cell;

Fig. 4a is a diagram showing a representative contact pitch distribution in the height direction for standard cells;

Fig. 4b is a diagram showing a representative contact pitch distribution in the width direction for standard cells.

DETAILED DESCRIPTION OF THE PREFERRED AND ALTERNATIVE EMBODIMENTS

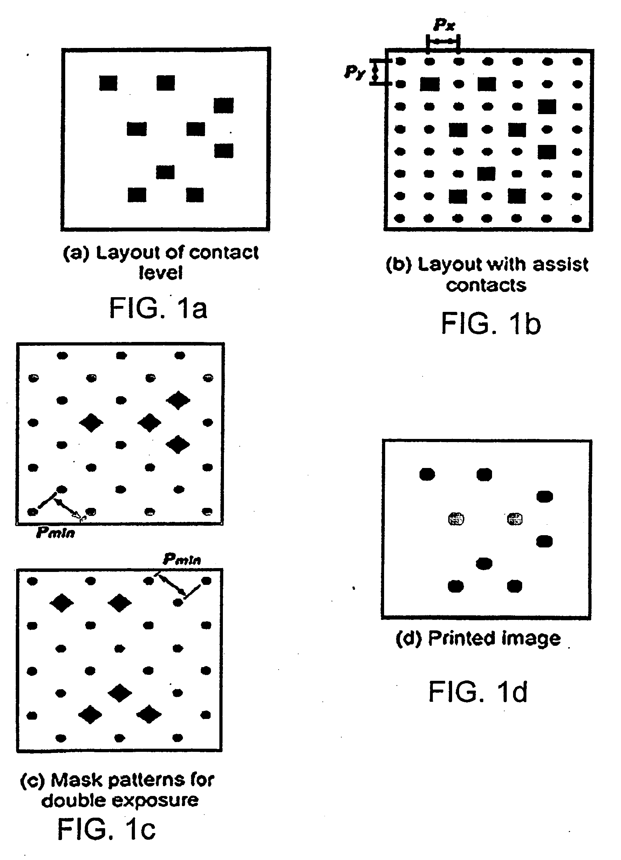

Fig. 1 illustrates one embodiment of the present invention. In fabrication-friendly layout, contacts are placed on a grid (Fig.1.a). Assist contacts are added into the grid points that do not have a contact (Fig.1.b). The assist contacts are sized such that they do not print onto the die but create a mask spectrum that allows the illumination to be optimized.
To get a smaller circuit area after snapping all contacts on a grid, the grid pitches in Fig.1.b, $p_x$ and $p_y$, are smaller than the minimum pitch of single-exposure lithography.
Although the pitch between contacts and assist contacts is smaller than the minimum pitch of single-exposure lithography, the pitches between any two real contacts always satisfy the design rule of the single-exposure lithography.
The dense grid of contacts and assist contacts (Fig.1.b) are separated into two sparser grids on two masks (Fig.1.c) with the grid pitch occurring at the diagonal direction:

$$p_{\min} = \sqrt{p_x^2 + p_y^2}, \qquad\qquad (3)$$

where $p_{\min}$ is the grid pitch of the sparser grid, $p_x$ and $p_y$ are two grid pitches of the dense grid in two perpendicular directions. Since the original dense grid is decomposed into several sparser ones, it is called a virtual grid. When $p_x$ is equal to $p_y$, $p_{\min}$ is roughly 144% of $p_x$ and $p_y$. Although $p_x$ and $p_y$ are smaller than the minimum pitch of single-exposure lithography, $p_{\text{mi}}$ can be larger than it. That makes the two sparser grids within the resolution limit of one exposure.
Sequential exposures of these two masks print all contacts on the virtual grid on the die (Fig.1.d). The regular placement of features in two masks enables lithography optimization and leads to a reduced minimum contact size and pitch. While an overlay error on either contact mask would reduce yield, and two masks will cost more than one, since mask write times depend on the number of features written, which remains constant, and faster tools can be used for larger pitches, reticle costs should not double. It should be noted that this double exposure method works because there are no nearest-neighboring contacts on the virtual grid. The particular example in Fig.1 places assist contacts or actual contacts at all virtual grid points. Without that RET-based restriction, a single contact mask might suffice for the contacts of Fig.1.a.
The inventors have discovered that the reduced virtual grid pitch, coupled with about a 10% reduction in CD, the result of the lithography optimization enabled by regular placement of contacts, negates the expansion of the circuit area resulting from the additional constraint placed on the layout step of requiring the contacts to be snapped to a grid and leads to smaller average standard cell area. Power consumption and intrinsic delay of standard cells also improve with the decrease of cell area.

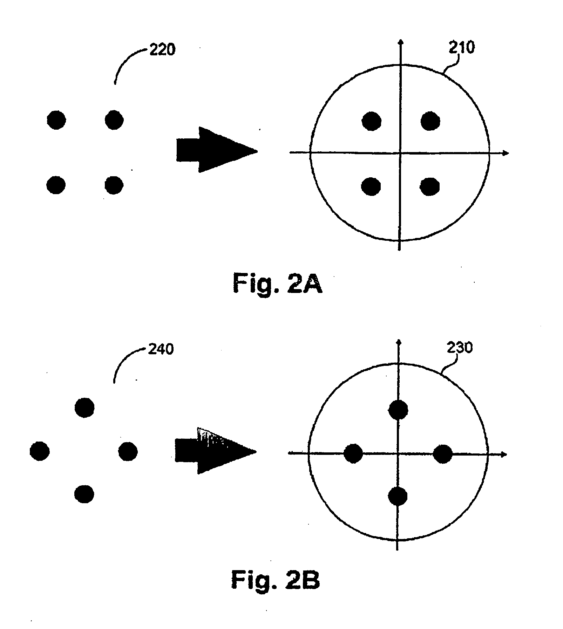

Fig. 2a is a diagram of the illumination source used for an X-Y grid layout. In one type of modified illumination RET, a quadrupole illumination source 210 is aligned to the grid axes of the grid 220. In one embodiment of the present invention, although the virtual grid has grid axes aligned with the X and Y directions, the first and second grid patterns 240 are aligned with the diagonal directions. In a preferred embodiment, the quadrupole illumination source 230 for the first and second grid patterns 240 are also aligned with the diagonal directions. The poles of quadrupole illumination 230 for the first and second grid patterns 240 are placed on the x- and y- axes with distances to zero point determined by $p_x$ and $p_y$.

A 250 nm standard cell library is used as an illustrative example of one embodiment of the present invention. Standard cells are important features for application-specific integrated circuit (ASIC) design. A standard cell based ASIC design typically comprises three types of cells: I/O cells, mega cells, and standard cells. I/O cell are laid on the periphery of the die as connection points to outside circuitry. Mega cells are typically pre-designed mega-logic features such as RAM and ROM. Standard cells are micro-logic features that primarily provide basic logic functions such as Boolean operations and flip-flops.

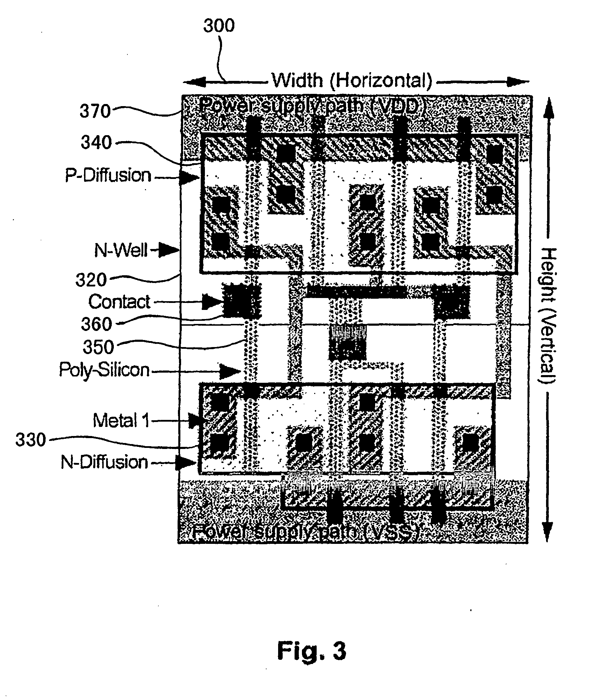

Fig. 3 is a diagram illustrating the feature of a standard cell 300. Each standard cell in a library is rectangular with a fixed height but varying widths. The cells are placed in rows with overlapping power supply paths. A standard cell typically has an N-well layer 320, an N-diffusion layer 330, a P-diffusion layer 340, a poly-silicon layer 350, a contact layer 360, and a metal-1 layer 370. The N-well 320, N-diffusion 330, P-diffusion 340 and poly-silicon 350 form P-MOS and N-MOS inside the cells. The poly-silicon 350 also serves as an intra-cell routing path. The contacts 360 form connections between the routing layers and the under layers.

The height of a cell is typically given as the number of metal-1 tracks over the cells in the height direction. A metal-1 track comprises the metal-1 path and the space between metal-1 paths. The typical height of a standard cell is 10 tracks, where three tracks are used for power supply paths and the remaining seven tracks are for intra-cell design. Because the height is fixed in a library, any change in area caused by snapping contacts to a grid is reflected as a change in the cell width.

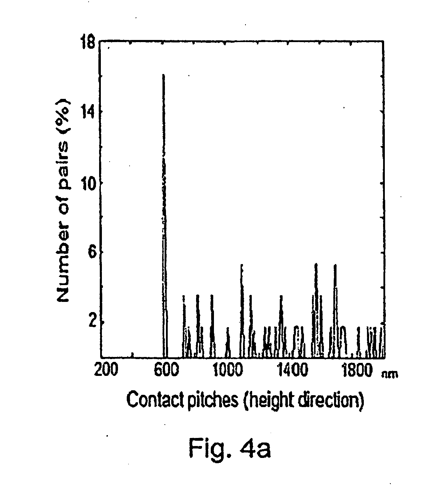

Fig. 4a is a diagram showing a representative contact pitch distribution of standard cells in the height direction. The most frequent pitch pair is about 600 nm, which most likely reflects the minimum pitch of the metal-1 path. Therefore the minimum pitch of the metal-1 path may be selected as the grid pitch or multiple of the grid pitch in the height direction. To get a smaller final cell area, a half of metal-1 pitch should be selected as the horizontal grid pitch, $p_y$, of regularly-placed contacts in standard cells to relax the layout restriction in the vertical direction.

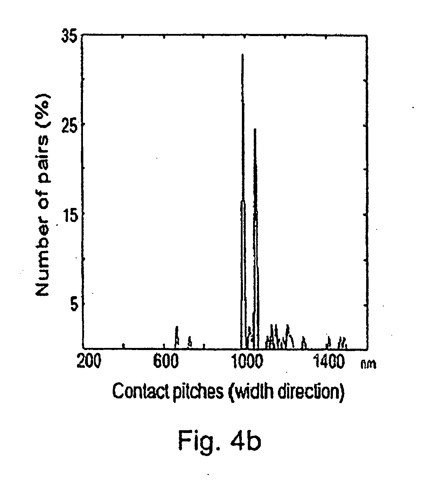

Fig. 4b is a diagram showing a representative contact pitch distribution of standard cells in the width direction. The minimum pitch pair is about 600 nm but the most frequent pitch pair is around 1000 nm. If the minimum pitch pair is selected as the grid pitch, the area of the cell will increase by about 20% because the most frequent pitch pairs at 1000 nm will rounded up to two grid pitches (1200 nm). Furthermore, Fig 4b shows two peaks near 1000 nm. The two peaks reflect the distance between the source and drain in two types of MOSFETs in the standard cell. The narrow gate MOSFET has a larger source to drain distance than the wide gate MOSFET, thereby creating a double-peaked contact pitch distribution. The double peak may be eliminated by increasing the width of some narrow gate MOSFETs.

Fig. 4b indicates that the most frequent pitch pair is the source - drain pitch. If the source - drain pitch is selected as the grid pitch in the horizontal direction, however, the contacts for the gate, which are typically placed in the middle of source and drain contacts, will have to be aligned with either the source or drain contacts resulting in a large cell area increase. Therefore, a half source - drain pitch should be selected as the horizontal grid pitch, $p_x$ of regularly-placed contacts in standard cells.

The desired grid pitches, $p_x$ and $p_y$, however, are smaller than the minimum pitch of the contact layer. The desired grid is decomposed into two interleaved grids. Each interleaved grid has its grid axes aligned along the diagonals of the desired grid with an interleaved grid pitch equal to the diagonal pitch of the desired grid.

Each grid location is populated by a real contact or an assist contact. The die is printed by projecting the first interleaved grid onto the die followed by projecting the second interleaved grid onto the die. The regular placement of features in two masks enables lithography optimization and leads to a reduced minimum contact size and pitch. The double exposure method creates the virtual grid on the die have the desired grid pitches from interleaved grids having pitches approximately 40% larger than the desired grid pitches.

Having described at least illustrative embodiments of the invention, various modifications and improvements will readily occur to those skilled in the art and are intended to be within the scope of the invention as defined by the appended claims. Accordingly, the foregoing description is by way of example only and is not intended as limiting.

## Claims

1.  A method of imaging features onto a wafer comprising:

    establishing a first grid having grid pitches ($P_x$, $P_y$);
    arranging a plurality of real features (360) on the first grid;
    arranging a plurality of assist features on the first grid;
    the assist features being sized such that they do not print but nevertheless create a mask spectrum that allows an illumination to be optimized;
    creating two masks, the first mask including a first subset of the plurality of real features (360) and the second mask containing a second subset of the plurality of real features (360); and

imaging the real features onto the wafer,

**characterized in that**

- the first mask includes a second grid and includes a first subset of the plurality of assist features; and
- the second mask includes a third grid and includes a second subset of the plurality of assist features, and
- the second grid and the third grid are sparser ($P_{min}$) than the first grid.

2. The method of imaging features according to claim 1, wherein the grid has a grid pitch $P_x$ in x direction and a grid pitch $P_y$ in the perpendicular direction of the x direction.

3. The method of imaging features according to claim 1, wherein the grid pitches are selected to minimize circuit area.

4. The method of imaging features according to claim 1, wherein assist features are arranged on all grid points of the first grid that do not have a real feature.

5. The method of imaging features onto a wafer according to claim 1, wherein the distance in the first grid between two of the plurality of assist features or one of the plurality of features and one of the plurality of assist features is smaller than a minimum pitch of a single-exposure lithography.

6. The method of imaging features onto a wafer according to claim 5, wherein the distance between two adjacent real features is not smaller than the minimum pitch of single-exposure lithography.

7. A method of imaging features onto a wafer according to claim 1, wherein the first and second masks are sequentially exposed to print features.

8. The lithography method according to claim 1, wherein the distance between two adjacent real features is not smaller than the minimum pitch of single-exposure lithography and the distance between two adjacent assist features or a real feature and an adjacent assist feature is smaller than the minimum pitch of single-exposure lithography.

9. The lithography method according to claim 8, wherein a diagonal distance between two adjacent real features, two adjacent assist features, or a real feature and an adjacent assist feature has a distance of $\sqrt{P_x^2 + P_y^2}$ where $P_x$ is the pitch between the two adjacent assist features, the two adjacent real features, or a real feature and an adjacent assist feature in an x direction and $P_y$ is the pitch between two adjacent assist features, the two adjacent real features, or a real feature and an adjacent assist feature in the perpendicular direction of the y direction.

10. A mask set for imaging a plurality of real features (360) and a plurality of assist features arranged in a first grid onto a die (300) wherein the assist features are sized such that they do not print but nevertheless create a mask spectrum on the die that allows an illumination to be optimized, the mask set comprising:

   a first mask including a first set of the plurality of real features (360); and
   a second mask including a second set of the plurality of real features (360);

**characterized in that**

- the first mask includes a second grid and includes a first subset of the plurality of assist features; and
- the second mask includes a third grid and includes a second subset of the plurality of assist features; and
- the second grid and the third grid are sparser ($P_{min}$) than the first grid ($P_x$, $P_y$).

11. A mask set for imaging a die according to claim 10, wherein the distance between two adjacent features in the second grid of the first mask or the third grid of the second mask are spaced at a pitch not smaller than a minimum pitch for a single-exposure lithography.

12. A mask set for imaging a die according to claim 11, wherein the first set of real features is distinct from the second set of real features.

**13.** A mask set for imaging a die according to claim 11, wherein the first set of assist contacts is distinct from the second set of assist contacts.

**14.** The mask set for imaging a die according to claim 11, wherein a diagonal distance between two neighboring features (real or assist features) has a distance of $\sqrt{P_x^2 + P_y^2}$ where $P_x$ is the pitch between two neighboring assist features or a real feature and a neighboring assist feature in an x direction and $P_y$ is the pitch between two neighboring assist features or a real feature and a neighboring assist feature in the perpendicular direction of the x direction.

**Patentansprüche**

**1.** Verfahren zur Abbildung von Merkmalen auf einem Wafer, umfassend:

die Etablierung eines ersten Rasters, der Rasterabstandsmaße ($P_x$, $P_y$) aufweist;
die Anordnung einer Mehrzahl von realen Merkmalen (360) auf dem ersten Raster;
die Anordnung einer Mehrzahl von Hilfsmerkmalen auf dem ersten Raster;
wobei die Hilfsmerkmale so dimensioniert werden, dass sie nicht drucken, sondern nichtsdestoweniger ein Maskenspektrum bilden, welches eine Optimierung einer Illumination erlaubt;
die Herstellung von zwei Masken, die erste Maske, umfassend eine erste Teilmenge der Mehrzahl von realen Merkmalen (360), und die zweite Maske, enthaltend eine zweite Teilmenge der Mehrzahl von realen Merkmalen (360); und
die Abbildung der realen Merkmale auf dem Wafer, **dadurch gekennzeichnet, dass**

- die erste Maske einen zweiten Raster enthält und eine erste Teilmenge der Mehrzahl von Hilfsmerkmalen enthält; und
- die zweite Maske einen dritten Raster enthält und eine zweite Teilmenge der Mehrzahl von Hilfsmerkmalen enthält, und
- der zweite Raster und der dritte Raster dünner sind ($P_{min}$) als der erste Raster.

**2.** Verfahren zur Abbildung von Merkmalen nach Anspruch 1, worin der Raster ein Rasterabstandsmaß $P_x$ in X-Richtung und ein Rasterabstandsmaß $P_y$ in der Richtung senkrecht zu der X-Richtung aufweist.

**3.** Verfahren zur Abbildung von Merkmalen nach Anspruch 1, worin die Rasterabstandsmaße zur Minimierung der Schaltungsfläche ausgewählt sind.

**4.** Verfahren zur Abbildung von Merkmalen nach Anspruch 1, worin die Hilfsmerkmale an allen Rasterpunkten des ersten Rasters angeordnet sind, welche kein reales Merkmal aufweisen.

**5.** Verfahren zur Abbildung auf einem Wafer nach Anspruch 1, worin der Abstand im ersten Raster zwischen zwei der Mehrzahl von Hilfsmerkmalen oder einem der Mehrzahl von Merkmalen und einem der Mehrzahl von Hilfsmerkmalen kleiner ist als ein Mindestabstandsmaß einer Einfachbelichtungslithographie.

**6.** Verfahren zur Abbildung von Merkmalen auf einem Wafer nach Anspruch 5, worin der Abstand zwischen zwei angrenzenden realen Merkmalen nicht kleiner ist als das Mindestabstandsmaß einer Einfachbelichtungslithographie.

**7.** Verfahren zur Abbildung von Merkmalen auf einem Wafer nach Anspruch 1, worin die erste und zweite Maske nacheinander belichtet werden um Merkmale zu drucken.

**8.** Lithographieverfahren nach Anspruch 1, worin der Abstand zwischen zwei angrenzenden realen Merkmalen nicht kleiner ist als das Mindestabstandsmaß einer Einfachbelichtungslithographie, und der Abstand zwischen zwei angrenzenden Hilfsmerkmalen oder einem realen Merkmal und einem angrenzenden Hilfsmerkmal kleiner ist als das Mindestabstandsmaß einer Einfachbelichtungslithographie.

**9.** Lithographieverfahren nach Anspruch 8, worin ein diagonaler Abstand zwischen zwei angrenzenden realen Merkmalen, zwei angrenzenden Hilfsmerkmalen oder einem realen Merkmal und einem angrenzenden Hilfsmerkmal einen Abstand von $\sqrt{p_x^2 + p_y^2}$ aufweist, wobei $P_x$ das Abstandsmaß zwischen den beiden angrenzenden Hilfsmerkmalen, den beiden angrenzenden realen Merkmalen oder einem realen Merkmal und einem angrenzenden Hilfsmerkmal in einer X-Richtung ist, und $P_y$ das Abstandsmaß zwischen zwei angrenzenden Hilfsmerkmalen, den beiden angrenzenden realen Merkmalen oder einem realen Merkmal und einem angrenzenden Hilfsmerkmal in der Richtung senkrecht zu der X-Richtung ist.

10. Maskenset zur Abbildung einer Mehrzahl von realen Merkmalen (360) und einer Mehrzahl von Hilfsmerkmalen, die in einem ersten Raster auf einer Druckplatte (300) angeordnet sind, wobei die Hilfsmerkmale so dimensioniert sind, dass sie nicht drucken, sondern nichtsdestoweniger ein Maskenspektrum auf der Druckplatte bilden, welches eine Optimierung einer Illumination erlaubt, wobei das Maskenset eine erste Maske umfasst, die ein erstes Set der Mehrzahl von realen Merkmalen (360) enthält, und eine zweite Maske, die ein zweites Set der Mehrzahl von realen Merkmalen (360) enthält, **dadurch gekennzeichnet, dass**

- die erste Maske einen zweiten Raster enthält und eine erste Teilmenge der Mehrzahl von Hilfsmerkmalen enthält; und
- die zweite Maske einen dritten Raster enthält und eine zweite Teilmenge der Mehrzahl von Hilfsmerkmalen enthält; und
- der zweite Raster und der dritte Raster dünner sind ($P_{min}$) als der erste Raster ($P_x$, $P_y$).

11. Maskenset zur Abbildung auf einer Druckplatte nach Anspruch 10, worin der Abstand zwischen zwei angrenzenden Merkmalen im zweiten Raster der ersten Maske oder im dritten Raster der zweiten Maske in einem Abstandsmaß angeordnet sind, das nicht kleiner ist als ein Mindestabstandsmaß für eine Einfachbelichtungslithographie.

12. Maskenset zur Abbildung auf einer Druckplatte nach Anspruch 11, worin sich das erste Set von realen Merkmalen vom zweiten Set von Hilfsmerkmalen unterscheidet.

13. Maskenset zur Abbildung auf einer Druckplatte nach Anspruch 11, worin sich das erste Set von Hilfsmerkmalen vom zweiten Set von Hilfskontakten unterscheidet.

14. Maskenset zur Abbildung auf einer Druckplatte nach Anspruch 11, worin ein diagonaler Abstand zwischen zwei benachbarten Merkmalen, realen Merkmalen oder Hilfismerkmalen, einen Abstand von $\sqrt{p_x^2 + p_y^2}$ aufweist, wobei $P_x$ das Abstandsmaß zwischen zwei benachbarten Hilfsmerkmalen oder einem realen Merkmal und einem benachbarten Hilfismerkmal in einer X-Richtung ist, und $P_y$ das Abstandsmaß zwischen zwei benachbarten Hilfsmerkmalen oder einem realen Merkmal und einem benachbarten Hilfsmerkmal in der Richtung senkrecht zu der X-Richtung ist.

**Revendications**

1. Procédé de formation d'image d'objets sur une plaquette comprenant :

l'établissement d'une grille ayant des pas ($P_x$, $P_y$) de grille ;
l'agencement d'une pluralité d'objets réels (360) sur la première grille ;
l'agencement d'une pluralité d'objets d'assistance sur la première grille ;
les objets d'assistance étant dimensionnés de façon qu'ils ne s'impriment pas mais créent néanmoins un spectre de masque qui permet que un éclairement soit optimisé ;
la création de deux masques, le premier masque incluant un premier sous-ensemble de la pluralité d'objets réels (360) et le second masque contenant un second sous-ensemble de la pluralité d'objets réels (360) ; et
la formation d'image des objets réels sur la plaquette,

**caractérisé :**

- **en ce que** le premier masque inclut une deuxième grille et inclut un premier sous-ensemble de la pluralité d'objets d'assistance ; et
- **en ce que** le second masque inclut une troisième grille et inclut un second sous-ensemble de la pluralité d'objets d'assistance ; et
- **en ce que** la deuxième grille et la troisième grille sont moins denses (P$_{min}$) que la première grille.

2. Procédé de formation d'image d'objets selon la revendication 1, dans lequel la grille a un pas P$_x$ de grille dans la direction x et un pas P$_y$ de grille dans la direction perpendiculaire à la direction x.

3. Procédé de formation d'image d'objets selon la revendication 1, dans lequel les pas de grille sont choisis pour minimiser la superficie de circuit.

4. Procédé de formation d'image d'objets selon la revendication 1, dans lequel les objets d'assistance sont agencés sur tous les points de grille de la première grille qui n'ont pas d'objet réel.

5. Procédé de formation d'image d'objets sur une plaquette selon la revendication 1, dans lequel la distance dans la première grille entre deux de la pluralité d'objets d'assistance ou entre l'un de la pluralité d'objets et l'un de la pluralité d'objets d'assistance est plus petite que le pas minimal d'une lithographie à simple exposition.

6. Procédé de formation d'image d'objets sur une plaquette selon la revendication 5, dans lequel la distance entre deux objets réels adjacents n'est pas plus petite que un pas minimal de lithographie à simple exposition.

7. Procédé de formation d'image d'objets sur une plaquette selon la revendication 1, dans lequel les premier et second masques sont exposés séquentiellement pour imprimer des objets.

8. Procédé de lithographie selon la revendication 1, dans lequel la distance entre deux objets réels adjacents n'est pas plus petite que le pas minimal de lithographie à simple exposition et dans lequel la distance entre deux objets d'assistance adjacents ou entre un objet réel et un objet d'assistance adjacent est plus petite que le pas minimal de lithographie à simple exposition.

9. Procédé de lithographie selon la revendication 8, dans lequel une distance en diagonale entre deux objets réels adjacents, entre deux objets d'assistance adjacents, ou entre un objet réel et un objet d'assistance adjacent est une distance de $\sqrt{P_x^2 + P_y^2}$ où P$_x$ est le pas entre les deux objets d'assistance adjacents, entre les deux objets réels adjacents, ou entre un objet réel et un objet d'assistance adjacent dans une direction x et P$_y$ est le pas entre deux objets d'assistance adjacents, entre les deux objets réels adjacents, ou entre un objet réel et un objet d'assistance adjacent dans la direction perpendiculaire à la direction X.

10. Ensemble de masques pour former l'image d'une pluralité d'objets réels (360) et d'une pluralité d'objets d'assistance agencées dans une première grille sur un circuit intégré (300) dans lequel les objets d'assistance sont dimensionnés de façon qu'ils ne s'impriment pas mais créent néanmoins un spectre de masque sur le circuit intégré qui permet que un éclairement soit optimisé, l'ensemble de masques comprenant :

un premier masque incluant un premier ensemble de la pluralité d'objets réels (360) ; et
un second masque incluant un second ensemble de la pluralité d'objets réels (360) ;

**caractérisé :**

- **en ce que** le premier masque inclut une deuxième grille et inclut un premier sous-ensemble de la pluralité d'objets d'assistance ; et
- **en ce que** le second masque inclut une troisième grille et inclut un second sous-ensemble de la pluralité d'objets d'assistance ; et
- **en ce que** la deuxième grille et la troisième grille sont moins denses (P$_{min}$) que la première grille (P$_x$, P$_y$).

11. Ensemble de masques pour former l'image d'un circuit intégré selon la revendication 10, dans lequel la distance entre deux objets adjacents dans la deuxième grille du premier masque ou dans la troisième grille du second masque est espacée à un pas qui n'est pas plus petit qu'un pas minimal pour une lithographie à simple exposition.

12. Ensemble de masques pour former l'image d'un circuit intégré selon la revendication 11, dans lequel le premier ensemble d'objets réels est distinct du second ensemble d'objets réels.

**13.** Ensemble de masques pour former l'image d'un circuit intégré selon la revendication 11, dans lequel le premier ensemble de contacts d'assistance est distinct du second ensemble de contacts d'assistance.

**14.** Ensemble de masques pour former l'image d'un circuit intégré selon la revendication 11, dans lequel une distance en diagonale entre deux objets voisins (objets réels ou d'assistance) est une distance de $\sqrt{P_x^2 + P_y^2}$ où $P_x$ est le pas entre deux objets d'assistance voisins ou entre un objet réel et un objet d'assistance voisin dans une direction x et $P_y$ est le pas entre deux objets d'assistance voisins ou entre un objet réel et un objet d'assistance voisin dans la direction perpendiculaire à la direction x.

(a) Layout of contact level

FIG. 1a

(b) Layout with assist contacts

FIG. 1b

(c) Mask patterns for double exposure

FIG. 1c

(d) Printed image

FIG. 1d

**Fig. 2A**

**Fig. 2B**

300

Width (Horizontal)

370

Power supply path (VDD)

340

P-Diffusion

N-Well

320

Contact

360

350

Poly-Silicon

Metal 1

330

N-Diffusion

Power supply path (VSS)

Height (Vertical)

# Fig. 3

Fig. 4a

Fig. 4b

## EP 1 597 631 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 60450496 B
- US 20020045134 A
- US 6150059 A
- US 20020166107 A
- US 6074787 A
- US 20020094482 A

**Non-patent literature cited in the description**

- **A.K Wong.** Resolution Enhancement Techniques in Optical Lithography. SPIE Press, 2001